# EUROPEAN PATENT APPLICATION

(11) **EP 4 036 897 A1**
(43) Date of publication of application: **03.08.2022**
(21) Application number: 20894101.3
(22) Date of filing: 11.11.2020
(51) Int. Cl.: G09F 9/30, H05K 5/00

(54) **ELECTRONIC DEVICE**

(30) Priority: 25.11.2019 CN 201911168369
(71) Applicant: GUANGDONG OPPO MOBILE TELECOMMUNICATIONS CORP., LTD., Dongguan, Guangdong 523860 (CN)
(72) Inventor: CUI, Zhijia, Dongguan, Guangdong 523860 (CN); YANG, Le, Dongguan, Guangdong 523860 (CN)
(74) Representative: Thorniley, Peter
(86) International application number: PCT/CN2020/128170
(87) International publication number: WO 2021/104024

(57) **Abstract**

An electronic device (10), comprising a folding screen (20) and a housing (40). The folding screen (20) is mounted on the housing (40), and the housing (40) comprises a rear cover (420) provided opposite to the folding screen (20). The folding screen (20) comprises a first area (240), a bending area (220), and a second area (260), wherein the first area (240) comprises a first connection end (242) adjacent to the bending area (220); when the folding screen (20) is in an unfolded state, a first distance is formed between the first connection end (242) and the rear cover (420); when the folding screen (20) is in a folded state, a display surface of the first area (240) is provided opposite to a display surface of the second area (260), a second distance is formed between the first connection end (242) and the rear cover (420), and the second distance is smaller than the first distance. A gap of a bent position of the electronic device (10) can be very small or even no gap exists, so that a foreign matter is not easy to enter.

## Description

This application claims priority of Chinese patent applications No. 201911168369.2 filed November 25, 2019, entitled "ELECTRONIC DEVICE", the contents of which are incorporated herein by reference in their entirety.

### TECHNICAL FIELD

The present disclosure relates to the field of electronic technology, and more particularly to an electronic device.

### BACKGROUND

In the related art, an electronic device with a foldable screen can provide a larger display area, but after the foldable screen that is folded inward, a bending area of the foldable screen requires a predetermined bending radius, resulting in a bending position of the electronic device cannot be closed. Thus, there is a predetermined gap, and foreign objects are easily got into the foldable screen to scratch it.

### SUMMARY

Embodiments of the present application provide an electronic device, which can improve a problem of existing of a gap in the bending position of the electronic device when the foldable screen is folded.

An embodiment of the present application provides an electronic device, comprising:
a foldable screen, comprising a bending area, a first area, and a second area, the bending area connects the first area and the second area, the bending area is configured to fold and unfold the foldable screen, and the first area comprises a first connection end adjacent to the bending area; and
a housing, wherein the foldable screen is mounted on the housing, and the housing comprises a back-cover disposed opposite to the foldable screen;
when the foldable screen is in an unfolded state, there is a first distance between the first connecting end and the back-cover;
when the foldable screen is in the folded state, the display surface of the first area and the display surface of the second area are arranged opposite to each other, the first connecting end and the back-cover have a second distance, and the second distance is smaller than the first distance.

### BRIEF DESCRIPTION OF THE DRAWINGS

In order to describe the technical solutions more clearly in the embodiments of the present application, the following will briefly introduce the drawings that need to be used in the description of the embodiments.
FIG. 1 is a schematic diagram of a first structure of an electronic device provided by an embodiment of the present application.
FIG. 2 is a cross-sectional view of the electronic device shown in FIG. 1 in the direction of A-A'.
FIG. 3 is a first structural schematic diagram of the electronic device shown in FIG. 1 in a folded state.
FIG. 4 is a schematic diagram of a second structure of the electronic device provided by an embodiment of the present application in an unfolded state.
FIG. 5 is a schematic structural diagram of the electronic device shown in Fig. 1 in a folded process.
FIG. 6 is a schematic diagram of a third structure of the electronic device provided by an embodiment of the present application in an unfolded state.
FIG. 7 is a schematic structural diagram of the electronic device shown in FIG. 6 in a folded state.
FIG. 8 is a schematic diagram of a fourth structure of the electronic device provided by an embodiment of the present application in an unfolded state.
FIG. 9 is a schematic diagram of a fifth structure of the electronic device provided by an embodiment of the present application in an unfolded state.
FIG. 10 is a schematic structural diagram of the electronic device shown in FIG. 9 in a folded state.

### DETAILED DESCRIPTION OF THE ILLUSTRATED EMBODIMENTS

The technical solutions in the embodiments of the present application will be clearly and completely described below in conjunction with the drawings in the embodiments of the present application. Obviously, the described embodiments are only a part of the embodiments of the present application, rather than all the embodiments. Based on the embodiments in this application, all other embodiments obtained by those skilled in the art without creative work shall fall within the protection scope of this application.

An embodiment of the present application provides an electronic device, comprising:
a foldable screen comprising a bending area, a first area, and a second area, wherein the bending area connects the first area and the second area, the bending area is configured to fold and unfold the foldable screen, and the first area comprises a first connection end adjacent to the bending area; and
a housing, wherein the foldable screen is mounted on the housing, and the housing comprises a back-cover disposed opposite to the foldable screen;
wherein a first distance is between the first connecting end and the back-cover when the foldable screen is in an unfolded state;
wherein a display surface of the first area and a display surface of the second area are arranged opposite to each other when the foldable screen is in the folded state, and the first connecting end and the back-cover have a second distance, and the second distance is smaller than the first distance.

In one embodiment, the back-cover comprises a first sub back-cover and a second sub back-cover, the first sub back-cover is disposed opposite to the first area, and the second back-cover opposite to the second area, the housing further comprises a first front housing disposed opposite to the first sub-back-cover, a second front housing disposed opposite to the second sub-back-cover, and the front housing is connected to the second front housing;
when the foldable screen is in a folded state, the first front housing comprises a first surface facing the second front housing, the second front housing comprises a second surface facing the first front housing., and the first surface is attached to the second surface.

In one embodiment, the second area comprises a second connecting end adjacent to the bending area;
when the foldable screen is in an unfolded state, the second connecting end and the second sub-back-cover has a being third distance;
when the foldable screen is in a folded state, the second connecting end and the second sub back-cover have a fourth distance, and the fourth distance is smaller than the third distance.

In one embodiment, the bending area comprises a first bending end connected to the first area, and a second bending end connected to the second area;
when the foldable screen is in the folded state, there is a fifth distance between the first bent end and the second bent end and a sixth distance is between the first area and the second area, and the sixth distance is smaller than the fifth distance.

In one embodiment, the first sub back-cover comprises a first sub back-cover end adjacent to the second sub-back-cover, and a second sub back-cover end disposed opposite to the first sub-back-cover end;
when the foldable screen is in the unfolded state, a distance between the second sub-back end and the first surface is smaller than a distance between the first sub-back end and the first surface.

In one embodiment, the electronic device further comprises an adjustment assembly, one end of the adjustment assembly is connected to the housing, the other end of the adjustment assembly is connected to the first area, and the adjustment assembly is configured to adjust its height to adjust the distance between the first area and the back-cover.

In one embodiment, the adjustment assembly comprises a driving part and a height adjustment part, the driving part is connected with the housing, and one end of the height adjustment part is drivingly connected with the driving part, the other end of the height adjustment part is connected to the first area, and the driving part is configured to drive and adjust the height of the height adjustment part.

In one embodiment, the electronic device further comprises a first connecting portion, one end of the first connecting portion is connected to the second sub-back-cover, and the other end of the first connecting portion is connected to the first area;

when the foldable screen is in a folded state, the first connecting portion is configured to pull the first area, so that the distance between the first area and the first sub-back-cover is smaller than the first distance.

In one embodiment, the electronic device further comprises a rotating shaft connecting the first sub back-cover and the second sub back-cover, the first sub-back-cover and the second sub-back-cover can rotate around the rotating shaft;
when the foldable screen is in a folded state, the first connecting portion bypasses the rotating shaft, and one end of the first connecting portion is located between the rotating shaft and the second area.

In one embodiment, the electronic device further comprises an auxiliary component, the auxiliary component is arranged on the first sub-back-cover;
when the foldable screen is in a folded state, the first connection part sequentially bypasses the rotating shaft and the auxiliary component.

In one embodiment, the first area is connected to the first sub back-cover through an elastic component, and when the foldable screen is in a folded state, the elastic component has an elastic restoring force, so the elastic restoring force is used to move the first area away from the first sub back-cover.

In one embodiment, the electronic device further comprises a second connecting portion, one end of the second connecting portion is connected to the first sub back-cover, and the other end of the second connecting portion is connected to the first sub back-cover;
when the foldable screen is in a folded state, the second connecting portion is configured to pull the second area, so that the distance between the second area and the second sub-back-cover is smaller than the first distance.

An embodiment of the present application provides an electronic device, comprising:
a foldable screen comprising a bending area, a first area, and a second area, wherein the bending area connects the first area and the second area, and the bending area is configured to fold and unfold the foldable screen, a display surface of the first area and a display surface of the second area are arranged opposite to each other when the foldable screen is in a folded state, and the first area comprises a first connecting end adjacent to the bending area; and
a housing, wherein the foldable screen is mounted on the housing, and the housing comprises a back-cover disposed opposite to the foldable screen;
an adjustment assembly, wherein one end of the adjustment assembly is connected to the housing, the other end of the adjustment assembly is connected to the first area, and the adjustment assembly is configured to adjust its height to adjust the first area and the back-cover;
when the foldable screen is in the unfolded state, the first connecting end of the first area has a first distance from the back-cover, and when the foldable screen is in the folded state, the relates to first connecting end of the first area has a second distance from the back-cover, and the second distance is smaller than the first distance.

In one embodiment, the adjustment assembly comprises a driving part and a height adjustment part, the driving part is connected with the housing, and one end of the height adjustment part is drivingly connected with the driving part, the other end of the height adjusting part is connected with the first area, and the driving part is used to drive and adjust a height of the height adjusting part.

An embodiment of the present application provides an electronic device, comprising:
a foldable screen, comprising a bending area, a first area, and a second area, the bending area connects the first area and the second area, the bending area is configured to fold and unfold the foldable screen, and the first area comprises a first connection end adjacent to the bending area; and
a housing, wherein the foldable screen is mounted on the housing, the housing comprises a back-cover disposed opposite to the foldable screen, the back-cover comprises a first sub back-cover and a second sub back-cover, the first sub back-cover is disposed opposite to the first area, the second back-cover is disposed opposite to the second area, and the housing further comprises a first front housing disposed opposite to the first sub-back-cover, and a second front housing disposed opposite to the second sub back-cover, and the first front housing is connected to the second front housing;
a first connecting portion, wherein one end of the first connecting portion is connected to the second sub-back-cover, and the other end of the first connecting portion is connected to the first area;
when the foldable screen is in an unfolded state, the first connecting end and the back-cover has a first distance;
when the foldable screen is in a folded state, the first front housing comprises a first surface facing the second front housing, the second front housing comprises a second surface facing the first front housing, the first surface is attached to the second surface, the display surface of the first area and the display surface of the second area are arranged oppositely, wherein the first connecting portion is configured to pull the first area to provide a second distance between the first area and the first sub back-cover, and the second distance is smaller than the first distance.

In one embodiment, the electronic device further comprises a rotating shaft connecting the first sub back-cover and the second sub back-cover, the first sub back-cover and the second sub back-cover rotate around the rotating shaft;
when the foldable screen is in a folded state, the first connecting portion bypasses the rotating shaft, and one end of the first connecting portion is located between the rotating shaft and the second area.

In one embodiment, the electronic device further comprises an auxiliary component, the auxiliary component is arranged on the first sub-back-cover, when the foldable screen is in a folded state, the first connection part sequentially bypasses the rotating shaft and the auxiliary component.

In one embodiment, the first area is connected to the first sub back-cover through an elastic component, and when the foldable screen is in a folded state, the elastic component has an elastic restoring force, so that the elastic restoring force is used to move the first area away from the first sub back-cover.

In one embodiment, the electronic device further comprises a second connecting portion, one end of the second connecting portion is connected to the first sub-back-cover, and the other end of the second connecting portion is connected to the first sub-back-cover;
when the foldable screen is in a folded state, the second connecting portion is configured to pull the second area, so that the distance between the second area and the second sub-back-cover is smaller than the first distance.

In one embodiment, the bending area comprises a first bending end connected to the first area, and a second bending end connected to the second area;
when the foldable screen is in the folded state, there is a fifth distance between the first bent end and the second bent end, a sixth distance is between the first area and the second area, and the sixth distance is smaller than the fifth distance.

An electronic device provided by an embodiment of the present application will be described in detail below. The electronic device can be a mobile terminal device such as mobile phones and tablet computers, as well as game devices, augmented reality (AR) devices, virtual reality (VR) devices, vehicle-mounted computers, notebook computers, data storage devices, audio playback devices, video playback devices, wearable devices, and other devices with display screens. The wearable devices can be smart bracelets, smart watches, smart glasses, and so on.

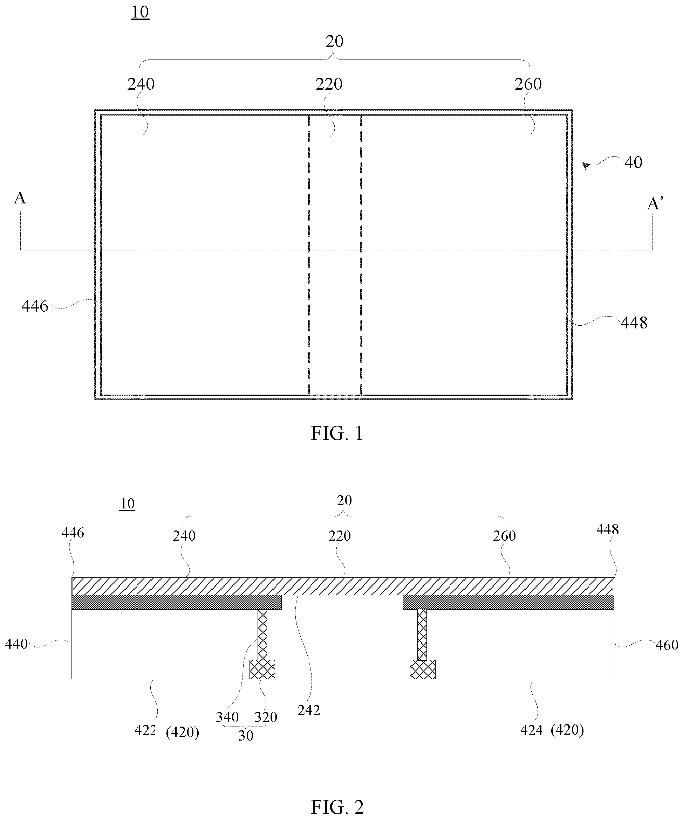

Please refer to FIGs. 1 and 2. FIG. 1 is a schematic diagram of a first structure of an electronic device provided by an embodiment of the application, and FIG. 2 is a cross-sectional view of the electronic device shown in FIG. 1 along the A-A' direction. The electronic device 10 may comprise a foldable screen 20 and a housing 40.

The foldable screen 20 comprises a bending area 220, a first area 240 and a second area 260. The bending area 220 connects the first area 240 and the second area 260. The bending area 220 is configured to fold and unfold the foldable screen 20. The first area 240 comprise a first connecting end 242 adjacent to the bending area 220. When the foldable screen 20 is in an unfolded state, the first area 240 and the second area 260 may be approximately in a plane and displayed together with the bending area 220 to provide a larger display area. When the foldable screen 20 is in a folded state, the bending area 220 is bent, and the first area 240 and the second area 260 connected thereto are covered.

The foldable screen 20 is installed in the casing 40, and the casing 40 comprises a back-cover 420 disposed opposite to the foldable screen 20. The back-cover 420 and the foldable screen 20 can be used as two opposite surfaces of the electronic device 10, the foldable screen 20 can be taken as a front side of the electronic device 10, and the back-cover 420 can be taken as a back side of the electronic device 10. The housing 40 can be configured to accommodate functional components such as the foldable screen 20, a circuit board, and a battery.

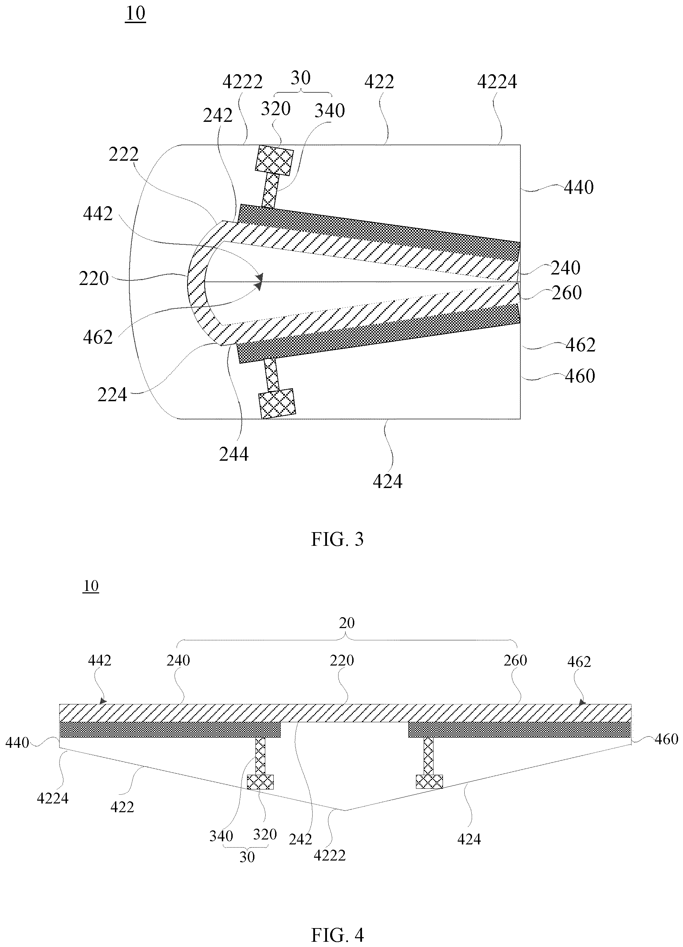

When the foldable screen 20 is in the unfolded state, the first connecting end 242 and the back-cover 420 have a first distance. Please refer to FIG. 3, which is a schematic diagram of the first structure of the electronic device shown in FIG. 1 in a folded state. When the foldable screen 20 is in the folded state, the display surface of the first area 240 and the display surface of the second area 260 are arranged oppositely. That is, the display surface of the first area 240 faces the display surface of the second area 260, which can also be understood as that the foldable screen 20 is an inwardly folded foldable screen 20. At this time, the first connecting end 242 and the back-cover 420 have a second distance, and the second distance is smaller than the first distance.

It should be noted that when the foldable screen 20 is in the folded state, the foldable screen 20 has a predetermined bending radius limitation in the bending state. That is, the bending area 220 cannot be completely folded in half, and the bending area 220 has a predetermined bending radius, which is Currently related to the characteristics of film materials of the foldable screen 20. When the inwardly folded foldable screen 20 is in the folded state, distances between the first connecting end 242 connecting the first area 240 and the back-cover 420 are smaller than those in the unfolded state. That is, when the foldable screen 20 is in the folded state, at this time the first connecting end 242 of the first area 240 has moved partly toward the back-cover 420, and the bending area 220 connected to the first connecting end 242 has also moved partly toward the back-cover 420, and the bending radius of the foldable screen 20 remains unchanged. In the housing of using the space in the housing 40 to accommodate the foldable area 220 in the folded state, the gap between the bending position of the electronic device 10 can be small or no gap, it is not easy for entering foreign objects, thereby protecting the foldable screen 20 from not easily being scratched by foreign objects entering the gap.

Specifically, the housing 40 may comprise a first sub-housing 440 and a second sub-housing 460. The first area 240 is installed in the first sub-housing 440, and the second area 260 is installed in the second sub-housing 460. The first sub-housing 440 and the second sub-housing 460 can also be switched between the unfolded state and the folded state. When the foldable screen 20 is in the unfolded state, the first sub-housing 440 and the second sub-housing 460 are also in the unfolded state. When the foldable screen 20 is in the folded state, the first sub-housing 440 and the second sub-housing 460 are also in the folded state.

It can also be understood that the back-cover 420 comprises a first sub back-cover 422 and a second sub back-cover 424, the first sub back-cover 422 is disposed opposite to the first area 240, the second back-cover 424 is disposed opposite to the second area 260, and the housing 40 also comprises a first front housing 446 arranged opposite to the first sub back-cover 422 and a second front housing 448 arranged opposite to the second sub back-cover 424. The first front housing 446 is connected to the second front housing 448. The first sub back-cover 422 and the first front housing 446 form a first sub-housing 440, and the second sub back-cover 424 and the second front housing 448 form a second sub-housing 460. The front housing formed by the first front housing 446 and the second front housing 448 is disposed around a periphery of the foldable screen.

When the foldable screen 20 is in the folded state, the first sub-housing 440 and the second sub-housing 460 are closed, the first front housing 446 comprises a first surface 442 facing the second front housing 448, and the second front housing 448 comprises the second surface 462 facing the first front housing 446. The first surface 442 and the second surface 462 are attached to each other.

When the inwardly folded foldable screen 20 is in the folded state, the distances between the first connecting end 242 connecting the first area 240 and the bending area 220 and the first sub-back-cover 422 are smaller than those in the unfolded state, and the distance between the end 242 and the first sub back-cover 422 is designed to be sufficiently small. That is, the first connecting end 242 moves a sufficient distance toward the first sub back-cover 422 so that the entire bending area 220 of the bending is arranged in the housing 40 so that the first surface 442 of the first front housing is attached to the second surface 462 of the second front housing. There is no gap at all in the bending position of the electronic device 10, and there is no gap allowing entering of foreign objects when the foldable screen 20 is in the folded state. The foldable screen 20 is better protected from being scratched by foreign objects. In addition to the first area 240 that can move toward the first sub-back-cover 422, the second area 260 can also move toward the second sub back-cover 424. Specifically, the second area 260 comprises a second connecting end 244 adjacent to the bending area 220. When the foldable screen 20 is in the unfolded state, the second connecting end 244 and the second sub back-cover 424 have a third distance. When the foldable screen 20 is in the folded state, the second connecting end 244 and the second sub back-cover 424 have a fourth distance, and the fourth distance is smaller than the third distance.

The second area 260 may have the same structure as the first area 240. For details, please refer to the above-mentioned embodiments, which will not be repeated here. It should be noted that the third distance between the second connecting end 244 of the second area 260 and the second sub back-cover 424 may be equal to the first distance, and the fourth distance between the second connection end 244 of the second area 260 and the second sub back-cover 424 may be equal to the second distance. The bending area 220 is symmetrically bent, the force is even, the bending area 220 can be protected, and the accommodation space corresponding to the movement interval of the foldable screen 20 in the housing 40 is also symmetrically arranged, which is convenient for design the electronic device 10.

In some other embodiments, the third distance may not be equal to the first distance, and/or the fourth distance may not be equal to the second distance. Different accommodation spaces of the electronic device 10 may be set up correspond to the first non-display area and the second non-display area to accommodate other functional components such as batteries and circuit boards.

It should be noted that in some other embodiments, only the first area 240 of the foldable screen 20 may move toward the first sub back-cover 422, the distance between the second area 260 and the second sub back-cover 424 remains unchanged, and the space in the sub-housing 460 is fixed so that functional components such as batteries and circuit boards can be conveniently arranged.

The bending area 220 comprises a first bending end 222 connected to the first area 240 and a second bending end 224 connected to the second area 260.

When the foldable screen 20 is in the folded state, there is a fifth distance between the first bending end 222 and the second bending end 224, there is a sixth distance between the first area 240 and the second area 260, and the sixth distance is less than the fifth distance. The sixth distance may be the distance between the middle of the first area 240 and the middle of the second area 260, or the distance between other positions of the first area 240 and the second area 260.

It can also be understood that the first area 240 and/or the second area 260 can only move at the end connected to the bending area 220, and the end away from the bending area 220 does not move, so that the sixth distance is smaller than the fifth distance, the connection strength between the foldable screen 20 and the casing 40 is improved, and the foldable screen 20 is not easily separated from the casing 40. It should be noted that the end of the first area 240 and/or the second area 260 away from the bending area 220 can also be moved, but its moving distance is less than the moving distance of one end of the first area 240 and/or the second area 260 connected to the bending area 220.

In some other embodiments, the first area and/or the second area can also move as a whole. That is, the first area and/or the second area as a whole move toward the back-cover, which helps to relieve the stress of the bending area after bending, and deduce the probability of damage to the foldable screen due to bending stress in the bending area.

Please refer to FIG. 4, which is a schematic diagram of the second structure of the electronic device provided by an embodiment of the present application in an unfolded state. The first back-cover 422 comprises a first back-cover end 4222 adjacent to the second back-cover 424, and a second back-cover end 4224 disposed opposite to the first back-cover end 4222. When the foldable screen is in the unfolded state, the distance between the second back-cover end 4224 and the first surface 442 is smaller than the distance between the first back-cover end 4222 and the first surface 442. Considering that when the foldable screen 20 is in a folded state, the bending area 220 needs a predetermined bending radius. The first area 240 and the second area 260 move a long distance to one end connected to it, while the other end away from the bending area 220 moves a smaller, and the housing can be set accordingly. For example, the first back-cover end 4222 of the first back-cover 422 and the second back-cover 424 of the first housing 440 are separated from the first surface 442 and the distance between the first back-cover end 4222 and the first surface 442 is larger, and the second back-cover end 4224 of the sub-back-cover 422 away from the second sub-back-cover 424 has a smaller distance from the first surface 442.

The structure of the second sub-back-cover 424 of the second sub-housing 460 may be the same as the structure of the first sub-back-cover 422. That is, the first sub back-cover 422 and the second sub back-cover 424 are symmetrically arranged. When the foldable screen 20 is in the unfolded state, the electronic device 10 may have a structure with a thick middle and thin end. The second sub back-cover 424 of the second sub-housing 460 may also be different from the first sub back-cover 422. That is, the distance between everywhere of the second sub back-cover 424 and the second surface 462 is approximately the same.

It should be noted that in some other embodiments, the distance between everywhere of the first sub back-cover and the first surface may be approximately the same, and the distance between the second sub back-cover and the second surface may be approximately the same. That is, the foldable screen is in the unfolded state, and the electronic device can have a regular or relatively regular rectangular structure.

The movement of the first area and/or the second area of the foldable screen toward the back-cover is achieved by corresponding moving functional components. The mobile function components are described in detail below.

Please continue to refer to FIGS. 2 to 3, the electronic device 10 further comprises an adjustment assembly 30, one end of the adjustment assembly 30 is connected to the housing, and the other end of the adjustment assembly 30 is connected to the first area 240. The adjustment assembly 30 is configured to adjust its height to adjust the distance between the first area 240 and the back-cover 420. In this embodiment, a mobile function assembly comprises an adjustment assembly. Herein, the other end of the adjusting assembly 30 and the first area 240 may be connected by sliding or rotating. The connection between the adjusting assembly 30 and the housing or the first area 240 can be a fixed connection or a rotating connection. The rotating connection can be understood as a first rotating part that is provided on the housing or the first area 240, the first rotating part is connected to the housing or the first area 240, and the adjustment assembly 30 is fixedly connected, so that the adjustment assembly 30 is rotatably connected with the housing or the first area 240. During the movement of the foldable screen, the first rotating part adjusts the angle of rotation correspondingly, which is convenient for the position adjustment of the adjustment assembly 30 and the housing or the first area 240 corresponding. Of course, in some other embodiments, the first rotating part may also be provided at one end of the adjustment assembly.

Specifically, the adjusting assembly 30 comprises a driving part 320 and a height adjusting part 340. The driving part 320 is connected to the housing, and one end of the height adjusting part 340 is drivingly connected to the driving part 320. That is, the driving part can drive the height adjusting part to move. One end of the height adjusting part 340 is connected to the first area 240, and the driving part 320 is used for driving and adjusting the height of the height adjusting part 340. The connection between the driving part 320 and the housing may be a fixed connection or a rotation connection. The connection between one end of the height adjustment part 340 and the first area 240 may be a fixed connection or a rotation connection. For details, please refer to the connection structure between the adjustment assembly and the housing or the first area and will not be repeated here.

The driving part 320 can adjust the height of the height adjusting part 340 so as to realize the movement of the first area 240 into the housing. For example, the driving part 320 may comprise a linear motor, and the height adjusting part 340 may be a threaded lifting column, and the linear motor may drive the threaded lifting column to be raised or lowered in its axial direction. Of course, the driving part 320 and the height adjusting part 340 may also be other components. The housing comprises the back-cover 420 and a middle plate. The middle plate is located between the back-cover 420 and the foldable screen 20. It can also be understood that the middle plate is in the electronic device 10, and the housing connected to the driving part 320 may be the back-cover 420 or the middle plate, and may also be other components connected to the back-cover 420 or the middle plate.

It can be understood that, in combination with the foregoing embodiments, when only the first area 240 is driven to move, there is one adjusting assembly30. When the first area 240 and the second area 260 are driven to move, the number of the adjustment assembly 30 can be two. That is, the two adjustment assemblies 30 drive the first area 240 and the second area 260 respectively, and the structure of the two adjustment assemblies 30 can be the same, and can be symmetrically arranged on both sides of the bending area 220. Of course, it can also be arranged asymmetrically as required.

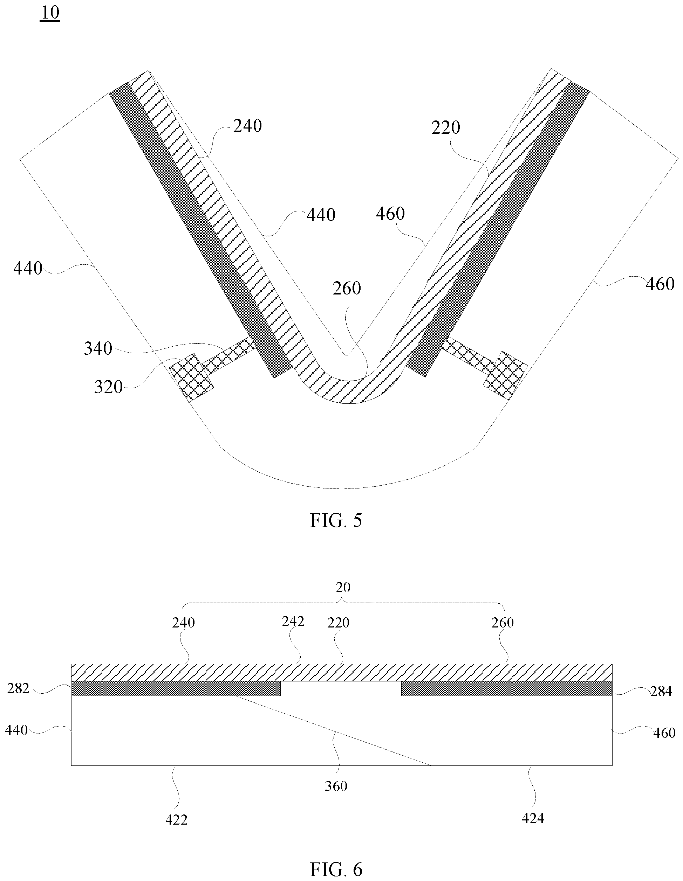

Please refer to FIG. 5, which is a schematic structural diagram of the electronic device shown in FIG. 1 in a foldable process. During the foldable process of the screen 20 from the unfolded state to the folded state, the height of the height adjusting part 340 gradually decreases, because one end of the height adjusting part 340 is connected to the housing, and the other end of the height adjusting part 340 will pull the upper first area and the second area to move to the housing, and the bending area 220 of the foldable screen 20 also moves in the direction of the housing. At this time, the planes of the first area and the second area are not in the same plane as the plane of the housing, and the foldable screen 20 is embedded in the housing, so that the electronic device 10 can be completely closed, and there is no problem of a large gap caused by the bending radius of the foldable screen 20.

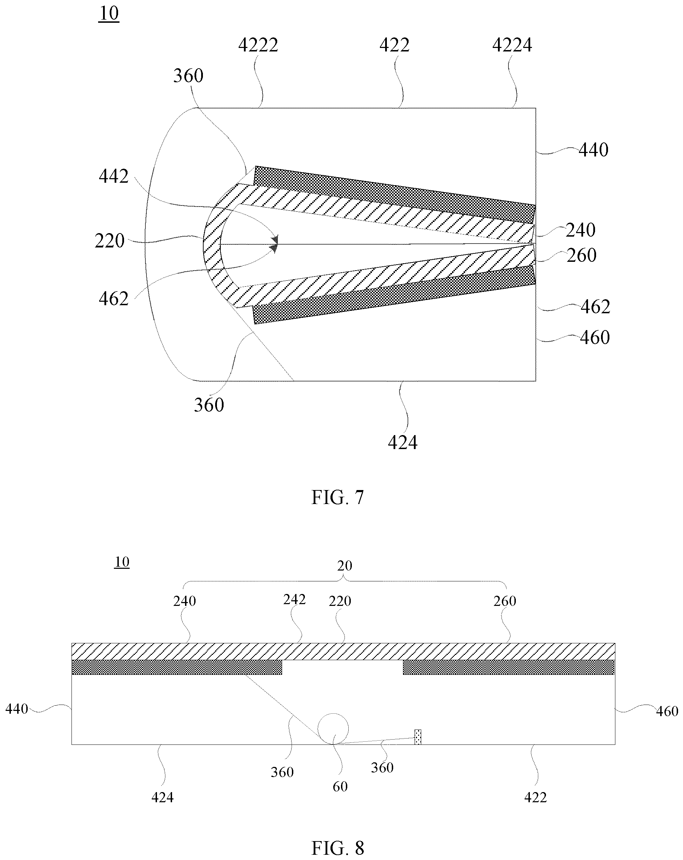

The mobile function component may also have other structures. Specifically, please refer to FIG. 6 and FIG. 7. FIG. 6 is a schematic diagram of a third structure of the electronic device provided by the embodiment of the application in an unfolded state. FIG. 7 is a schematic structural diagram of the electronic device shown in FIG. 6 in a folded state. The housing comprises a first sub-housing 440 and a second sub-housing 460. The first area 240 is installed in the first sub-housing 440, and the second area 260 is installed in the second sub-housing 460. The electronic device 10 further comprises a flexible first connecting portion 360. One end of the first connecting portion 360 is connected to the second sub back-cover 424 of the second sub-housing 460, and the other end of the first connecting portion 360 is connected to the first area 240. When the foldable screen 20 is in the folded state, the first connecting portion 360 is configured to pull the first area 240 so that the distance between the first area 240 and the first sub back-cover 422 is reduced and is smaller than the first distance. In this embodiment, the mobile function component comprises a first connecting portion 360.

One end of the first connecting portion 360 is connected to the second sub back-cover 424 of the second sub-housing 460, and the other end is connected to the first area 240 of the first sub-housing 440. When a user folds the electronic device 10, the first sub-housing housing 440 and the second sub-housing 460 are covered, the distance between the second sub-housing 460 and the first area 240 mounted on the first sub-housing 440 becomes longer, and one end of the flexible first connecting plate follows the movement of the second sub-housing 460 to drive the other end of the first connecting plate. The first area 240 can move relative to the first sub-housing 440, thereby driving the first area 240 to move toward the back-cover 420. Herein, the connection between the first connecting portion 360 and the second sub back-cover 424 or the first area 240 may be a fixed connection or a rotation connection. The rotation connection may be understood as a second sub back-cover 242 or the first area 240 is provided with the second rotating part that rotates. The first connecting part 360 is fixedly connected to the second rotating part, and the first connecting part realizes the rotating connection with the second sub back-cover 242 or the first area 240 through the second rotating part. In some other embodiments, the second rotating part may also be provided on the first connecting part.

Please refer to FIG. 8, which is a schematic diagram of a fourth structure of the electronic device provided by an embodiment of the application in an unfolded state. The electronic device 10 further comprises a rotating shaft 60 connected to the first sub-housing 440 and the second sub-housing 460, and the first sub-housing 440 and the second sub-housing 460 can rotate around the rotating shaft 60. When the foldable screen 20 is in the folded state, the first connecting portion 360 bypasses the rotating shaft 60, and one end of the first connecting portion 360 is located between the rotating shaft 60 and the second area 260.

The first connecting portion 360 bypasses the rotating shaft 60, and one end is connected to the second sub-housing 460 and the other end is connected to the first area 240 installed in the first sub-housing 440. When the electronic device 10 is unfolded, both ends of the first connecting portion 360 are located between the foldable screen 20 and the rotating shaft 60. In other words, both ends of the first connecting part 360 are on the side of the rotating shaft 60 facing the foldable screen 20, and the first connecting part 360 also bypasses the rotating shaft 60 in the middle. When the device 10 is folded, the first sub-housing 440 and the second sub-housing 460 rotate around the rotating shaft 60 and are covered. Because the first connecting part 360 also bypasses the rotating shaft 60 in the middle, both ends of the first connecting part 360 are located at the rotating shaft 60 between the first connecting portion 360 and the foldable screen 20. Both ends of the first connecting portion 360 receive a pulling force, the first connecting portion 360 is connected to the second sub-housing 460, and the first area 240 and the first sub-housing 440 can be movably connected. The first connecting portion 360 can drive the first area 240 to move toward the first sub back-cover 422. The first connecting portion 360 may be a chain, a belt, a hinge, or the like. The first connecting portion 360 may be made of an elastic material, or may be made of an inelastic material such as a metal rope. The number of the first connecting portion 360 can be one, but in order to control the movement of the first area 240 more smoothly and safely, the number of the first connecting portion 360 can also be multiple, the force is more uniform, and even if one of the first connecting part 360 is broken, the function of moving the first area 240 can also be realized through other first connecting portions 360.

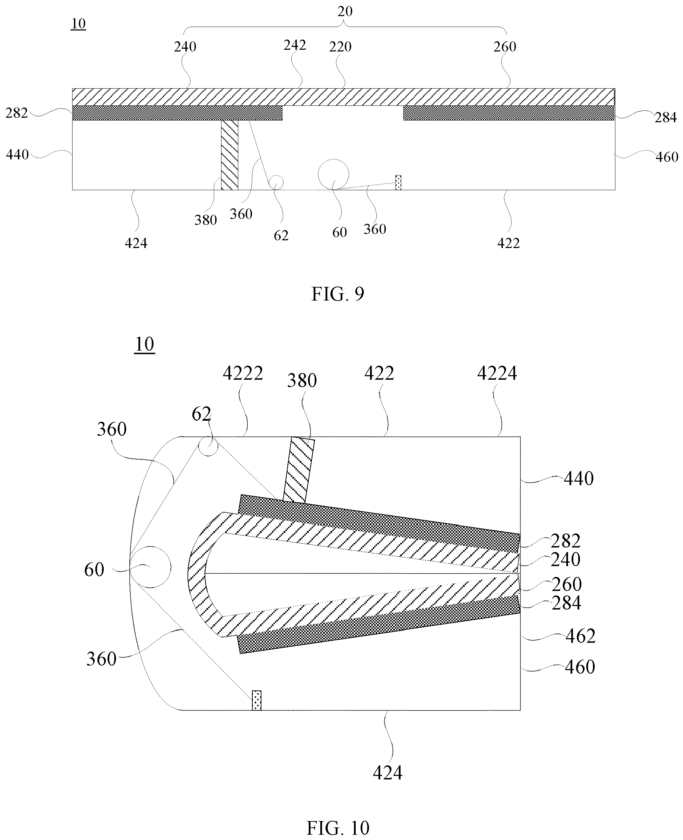

Please refer to FIG. 9 and FIG. 10. FIG. 9 is a schematic diagram of a fifth structure of the electronic device provided by an embodiment of the application in an unfolded state. FIG. 10 is a schematic structural diagram of the electronic device shown in FIG. 9 in a folded state. In order to allow the first connecting portion 360 to better control the first area 240, an auxiliary component 62 may also be provided on the first sub-housing 460, and the first connecting portion 360 fixedly arranged on the second sub-housing 460 bypasses the housing first. The middle rotating shaft 60 bypasses the auxiliary component 62 of the first sub-housing, and then connects to the first area 240 located in the first sub-housing. The first connecting portion 360 will not rub against the components in the electronic device and it will be stressed in more reasonable ways and is more convenient to pull the first area 240.

In order to allow the first area to move toward the back-cover better, a guide rail may be further provided on the first sub-housing, and the first area is installed on the guide rail, so that the first area moves in a preset direction.

The first area 240 may be connected to the first sub back-cover 422 of the first sub-housing 440 through an elastic component 380. When the foldable screen 20 is in the folded state, the elastic component 380 has elastic restoring force, which is configured to move the first area 240 in a direction away from the first sub-back-cover 422.

The first area 240 implements a movement function through a mechanical structure (the first connecting portion 360). When the electronic device 10 is transformed from the folded state to the unfolded state, the first area 240 can be restored to the unfolded state through the elastic component 380. The elastic component 380 may be a spring, rubber, or the like.

Herein, the housing comprises a back-cover and a middle plate. The middle plate is located between the back-cover and the foldable screen. It can also be understood that the middle plate is in the electronic device. The housing connected to the first connecting portion can be a back-cover or a middle plate. The board can also be other components connected to the back-cover or the middle board. The housing may also comprise a frame, and the frame and the middle plate may constitute the middle frame of the electronic device.

The electronic device further comprises a second connection part, one end of the second connection part is connected to the first sub-housing, and the other end of the second connection part is connected to the second area. When the foldable screen is in the folded state, the second connecting portion is configured to pull the second area, so that the distance between the second area and the back-cover is reduced and is smaller than the first distance.

The structure of the second connection part can be similar to that of the first connection part. The second connection part is configured to control the second area. The first connection part and the second connection part work together to control the first area and the second area at the same time, thereby better controlling the movement of the first area and the second area of the foldable screen.

It is understandable that the mobile functional component may connect the first area and the second area at one end of the adjacent bending area, or may connect the middle position of the first area and the second area.

It should be noted that please continue to FIG. 8 and 9, the back of the first area 240 is provided with a first structural member 282 attached to it, and the back of the second area 260 is provided with a second structural member 284 attached to it. Since the bending area 220 is need to bend, the back of the structure can be provided with no component. In the above-mentioned embodiments, the connection with the first area 240 can be understood as a connection through the first structural member 282, and the connection with the second region 260 can be understood as a connection through the second structural member 284. Of course, if the first area 240 and the second area 260 are not provided with corresponding structural members and are connected to the first area 240 and the second area 260, it can also be understood as being directly connected to the back of the first area 240 and the second area 260. The first structural member 282 and the second structural member 284 may be a hard structure, such as a steel plate, an alloy plate, or the like.

The electronic device also comprises a processor. When the unfoldable instruction is detected, the processor controls the first area and/or the second area to move toward its display surface, so that the bending area, the first area and the second area are flush; when 260. a foldable instruction is detected, the processor controls the first area and/or the second area to move in a direction away from its display surface. Wherein, the distance between the first area and the back-cover may be related to the foldable angle of the foldable screen. For example, the corresponding relationship between the distance between the first area and the back-cover and the foldable angle of the foldable screen can be stored in advance. After the foldable angle of the foldable screen is obtained, the distance between the first area and the back-cover is obtained according to a foldable angle value, and then control the adjustment assembly according to the foldable angle value so that the spacing between the first area and the back-cover is foldable angle value. Among them, the larger the bending angle (the maximum bending angle when the foldable screen is fully folded), the smaller the distance between the first area and the back-cover.

Among them, the foldable screen may be an integral screen, that is, the foldable screen is a flexible display screen, and the content displayed on the foldable screen is a complete image, with no non-display areas such as black borders in the middle. The foldable screen can also be a spliced screen, the first area and the second area are non-bendable display screens, the bending area is a bendable flexible display screen, the first area, the second area, and the bending area are spliced to form a fold Screen.

In the description of this application, the terms "first" and "second" are only used for descriptive purposes, and cannot be understood as indicating or implying relative importance or implicitly indicating the number of indicated technical features. Therefore, the features defined with "first" and "second" may explicitly or implicitly comprise one or more of the features. In the description of the present application, "multiple" means two or more than two, unless otherwise specifically defined.

The electronic device provided in the embodiment of the present application has been described in detail above. Specific examples are used in this article to illustrate the principles and implementations of the application, and the description of the above examples is only configured to help understand the application. At the same time, for those skilled in the art, according to the idea of this application, there will be changes in the specific implementation and the scope of application. In summary, the content of this specification should not be construed as a limitation to this application.

## Claims

1. An electronic device, comprising:
a foldable screen comprising a bending area, a first area, and a second area, wherein the bending area connects the first area and the second area, the bending area is configured to fold and unfold the foldable screen, and the first area comprises a first connection end adjacent to the bending area; and
a housing, wherein the foldable screen is mounted on the housing, and the housing comprises a back-cover disposed opposite to the foldable screen;
wherein a first distance is between the first connecting end and the back-cover when the foldable screen is in an unfolded state;
wherein a display surface of the first area and a display surface of the second area are arranged opposite to each other when the foldable screen is in the folded state, and the first connecting end and the back-cover have a second distance, and the second distance is smaller than the first distance.

2. The electronic device according to claim 1, wherein the back-cover comprises a first sub back-cover and a second sub back-cover, the first sub back-cover is disposed opposite to the first area, and the second back-cover opposite to the second area, the housing further comprises a first front housing disposed opposite to the first sub-back-cover, a second front housing disposed opposite to the second sub-back-cover, and the front housing is connected to the second front housing;
when the foldable screen is in a folded state, the first front housing comprises a first surface facing the second front housing, the second front housing comprises a second surface facing the first front housing., and the first surface is attached to the second surface.

3. The electronic device according to claim 2, wherein the second area comprises a second connecting end adjacent to the bending area;
when the foldable screen is in an unfolded state, the second connecting end and the second sub-back-cover has a third distance;
when the foldable screen is in a folded state, the second connecting end and the second sub back-cover have a fourth distance, and the fourth distance is smaller than the third distance.

4. The electronic device according to claim 1, wherein the bending area comprises a first bending end connected to the first area, and a second bending end connected to the second area;
when the foldable screen is in the folded state, there is a fifth distance between the first bent end and the second bent end and a sixth distance is between the first area and the second area, and the sixth distance is smaller than the fifth distance.

5. The electronic device according to claim 2, wherein the first sub back-cover comprises a first sub back-cover end adjacent to the second sub-back-cover, and a second sub back-cover end disposed opposite to the first sub-back-cover end;
when the foldable screen is in the unfolded state, a distance between the second sub-back end and the first surface is smaller than a distance between the first sub-back end and the first surface.

6. The electronic device according to claim 1, wherein the electronic device further comprises an adjustment assembly, one end of the adjustment assembly is connected to the housing, the other end of the adjustment assembly is connected to the first area, and the adjustment assembly is configured to adjust its height to adjust the distance between the first area and the back-cover.

7. The electronic device according to claim 6, wherein the adjustment assembly comprises a driving part and a height adjustment part, the driving part is connected with the housing, and one end of the height adjustment part is drivingly connected with the driving part, the other end of the height adjustment part is connected to the first area, and the driving part is configured to drive and adjust the height of the height adjustment part.

8. The electronic device according to claim 2, wherein the electronic device further comprises a first connecting portion, one end of the first connecting portion is connected to the second sub-back-cover, and the other end of the first connecting portion is connected to the first area;
when the foldable screen is in a folded state, the first connecting portion is configured to pull the first area, so that the distance between the first area and the first sub-back-cover is smaller than the first distance.

9. The electronic device according to claim 8, wherein the electronic device further comprises a rotating shaft connecting the first sub back-cover and the second sub back-cover, the first sub-back-cover and the second sub-back-cover can rotate around the rotating shaft;
when the foldable screen is in a folded state, the first connecting portion bypasses the rotating shaft, and one end of the first connecting portion is located between the rotating shaft and the second area.

10. The electronic device according to claim 9, wherein the electronic device further comprises an auxiliary component, the auxiliary component is arranged on the first sub-back-cover;
when the foldable screen is in a folded state, the first connection part sequentially bypasses the rotating shaft and the auxiliary component.

11. The electronic device according to claim 8, wherein the first area is connected to the first sub back-cover through an elastic component, and when the foldable screen is in a folded state, the elastic component has an elastic restoring force, so the elastic restoring force is used to move the first area away from the first sub back-cover.

12. The electronic device according to claim 8, wherein the electronic device further comprises a second connecting portion, one end of the second connecting portion is connected to the first sub back-cover, and the other end of the second connecting portion is connected to the first sub back-cover;
when the foldable screen is in a folded state, the second connecting portion is configured to pull the second area, so that the distance between the second area and the second sub-back-cover is smaller than the first distance.

13. An electronic device, comprising:
a foldable screen comprising a bending area, a first area, and a second area, wherein the bending area connects the first area and the second area, and the bending area is configured to fold and unfold the foldable screen, a display surface of the first area and a display surface of the second area are arranged opposite to each other when the foldable screen is in a folded state, and the first area comprises a first connecting end adjacent to the bending area; and
a housing, wherein the foldable screen is mounted on the housing, and the housing comprises a back-cover disposed opposite to the foldable screen;
an adjustment assembly, wherein one end of the adjustment assembly is connected to the housing, the other end of the adjustment assembly is connected to the first area, and the adjustment assembly is configured to adjust its height to adjust the first area and the back-cover;
when the foldable screen is in the unfolded state, the first connecting end of the first area has a first distance from the back-cover, and when the foldable screen is in the folded state, the first connecting end of the first area has a second distance from the back-cover, and the second distance is smaller than the first distance.

14. The electronic device according to claim 13, wherein the adjustment assembly comprises a driving part and a height adjustment part, the driving part is connected with the housing, and one end of the height adjustment part is drivingly connected with the driving part, the other end of the height adjusting part is connected with the first area, and the driving part is used to drive and adjust a height of the height adjusting part.

15. An electronic device, comprising:
a foldable screen, comprising a bending area, a first area, and a second area, the bending area connects the first area and the second area, the bending area is configured to fold and unfold the foldable screen, and the first area comprises a first connection end adjacent to the bending area; and
a housing, wherein the foldable screen is mounted on the housing, the housing comprises a back-cover disposed opposite to the foldable screen, the back-cover comprises a first sub back-cover and a second sub back-cover, the first sub back-cover is disposed opposite to the first area, the second back-cover is disposed opposite to the second area, and the housing further comprises a first front housing disposed opposite to the first sub-back-cover, and a second front housing disposed opposite to the second sub back-cover, and the first front housing is connected to the second front housing;
a first connecting portion, wherein one end of the first connecting portion is connected to the second sub-back-cover, and the other end of the first connecting portion is connected to the first area;
when the foldable screen is in an unfolded state, the first connecting end and the back-cover has a first distance;
when the foldable screen is in a folded state, the first front housing comprises a first surface facing the second front housing, the second front housing comprises a second surface facing the first front housing, the first surface is attached to the second surface, the display surface of the first area and the display surface of the second area are arranged oppositely, wherein the first connecting portion is configured to pull the first area to provide a second distance between the first area and the first sub back-cover, and the second distance is smaller than the first distance.

16. The electronic device according to claim 15, wherein the electronic device further comprises a rotating shaft connecting the first sub back-cover and the second sub back-cover, the first sub back-cover and the second sub back-cover rotate around the rotating shaft;
when the foldable screen is in a folded state, the first connecting portion bypasses the rotating shaft, and one end of the first connecting portion is located between the rotating shaft and the second area.

17. The electronic device according to claim 16, wherein the electronic device further comprises an auxiliary component, the auxiliary component is arranged on the first sub-back-cover, when the foldable screen is in a folded state, the first connection part sequentially bypasses the rotating shaft and the auxiliary component.

18. The electronic device according to claim 15, wherein the first area is connected to the first sub back-cover through an elastic component, and when the foldable screen is in a folded state, the elastic component has an elastic restoring force, so that the elastic restoring force is used to move the first area away from the first sub back-cover.

19. The electronic device according to claim 15, wherein the electronic device further comprises a second connecting portion, one end of the second connecting portion is connected to the first sub-back-cover, and the other end of the second connecting portion is connected to the first sub-back-cover;
when the foldable screen is in a folded state, the second connecting portion is configured to pull the second area, so that the distance between the second area and the second sub-back-cover is smaller than the first distance.

20. The electronic device according to claim 15, wherein the bending area comprises a first bending end connected to the first area, and a second bending end connected to the second area;
when the foldable screen is in the folded state, there is a fifth distance between the first bent end and the second bent end, a sixth distance is between the first area and the second area, and the sixth distance is smaller than the fifth distance.
